Europäisches Patentamt

European Patent Office

Office européen des brevets

(11) Veröffentlichungsnummer: **0 447 948 A1**

# (12) EUROPÄISCHE PATENTANMELDUNG

(21) Anmeldenummer: **91103884.2**

(22) Anmeldetag: **14.03.91**

(51) Int. Cl.$^5$: **G11B 5/72**, G11B 11/10, C23C 14/16, C23C 14/58

(30) Priorität: **22.03.90 DE 4009211**

(43) Veröffentlichungstag der Anmeldung: **25.09.91 Patentblatt 91/39**

(84) Benannte Vertragsstaaten: **DE FR GB NL**

(71) Anmelder: **BASF Aktiengesellschaft Carl-Bosch-Strasse 38 W-6700 Ludwigshafen(DE)**

(72) Erfinder: **Harth, Klaus, Dr. Starenweg 6 W-6719 Altleiningen(DE)** Erfinder: **Werner, Arend, Dr. Hammelstalstrasse 35 W-6702 Bad Duerkheim(DE)** Erfinder: **Hibst, Hartmut, Dr. Sternstrasse 215 W-6700 Ludwigshafen(DE)**

(54) Dünne transparente Korrosionsschutzschichten und Verfahren zu ihrer Herstellung.

(57) Die Erfindung betrifft dünne transparente Korrosionsschutzschichten, welche im wesentlichen aus Chrom und Chromoxid bestehen, für homogene, zur Speicherung von Informationen geeignete Metalldünnschichten sowie ein Verfahren zu ihrer Herstellung.

EP 0 447 948 A1

Die Erfindung betrifft dünne transparente Korrosionsschutzschichten für homogene, zur Speicherung von Informationen geeignete Metalldünnschichten sowie ein verfahren zu ihrer Herstellung.

Zur Erhöhung der Informationsdichte im Falle magnetischer Aufzeichnungsträger wurde schon mehrfach vorgeschlagen, die Pigment/Bindemittel-Magnetschicht durch einen solche aus ferromagnetischem Material in Form einer Metalldünnschicht zu ersetzen. Durch die mit einer Metalldünnschicht mögliche Anhebung der Koerzivfeldstärke einerseits und der wegen der größeren Magnetisierung der verwendeten ferromagnetischen Metalle bzw. Legierungen möglichen Verringerung der Schichtdicke auf unter 1000 nm andererseits läßt sich eine deutlich höhere Speicherdichte erreichen. Diese Metalldünnschichten bestehen bevorzugt aus Co-haltigen Legierungen mit Zusätzen von beispielsweise Ni, Cr, Pt, Ta,W, Mn, Mo oder V. Sie werden bevorzugt durch PVD-verfahren, wie Kathodenzerstäuben oder Aufdampfen hergestellt. Diese dünnen Metallschichten müssen jedoch gegen Korrosion geschützt werden.

Für die magnetooptische Datenaufzeichnung können unterschiedliche Materialien eingesetzt werden, wie zum Beispiel kristalline Granat-Schichten, polykristalline Mn-Bi-Schichten oder amorphe Schichten aus Seltenen-Erden-Übergangsmetall-Legierungen, wie Tb-Fe, Gd-Co, TbGd-Fe, Tb-Fe-Co, etc., im folgenden (RE-TM)-Metalle genannt. Neuerdings werden diese amorphen (RE-TM)-Schichten bevorzugt, da diese Aufzeichnungsschichten großflächig durch Kathodenzerstäubungsmethoden oder durch Aufdampfmethoden hergestellt werden können, und die aufgezeichneten Signale mit einem geringen Rauschen ausgelesen werden können. Ein großer Nachteil der erwähnten (RE-TM)-Legierungen ist ihre mangelnde Korrosionsbeständigkeit. Bei direktem Kontakt der Schichten mit Luft oder Wasserdampf erfolgt eine fortschreitende großflächige Oxidation der magnetooptischen Schicht, die eine Reduktion des Kerr-Drehwinkels und der Reflektivität und schließlich einen Verlust der gespeicherten Speicherinformation zur Folge hat.

In der optischen Datenaufzeichnung finden kohärente Chalkogenidverbindungen Anwendung. Auch diese Schichten zeichnen sich durch eine hohe Anfälligkeit gegenüber Oxidation aus.

Eine Möglichkeit der Verbesserung der Korrosionsbeständigkeit von kohärenten Aufzeichnungsträgern bietet die Abscheidung von vorder- und/oder rückseitigen Schutzschichten auf die Speicherschicht zur Vermeidung des direkten Luft-Kontaktes der Metallschicht sowie zur Unterbindung der Diffusion von Sauerstoff oder Wasser. Eine Unterbindung dieser Diffusion ist jedoch nur durch sehr dichte riß- und porenfreie Schutzschichten möglich.

Die zusätzliche Abscheidung der Schutzschichten führt aber zu einer wesentlichen Verlängerung und Verteuerung des Produktionsprozesses. Außerdem erfordern die verschiedenen Arten der Datenaufzeichnung noch weitere und unterschiedliche Eigenschaften der Schutzschicht.

Bei der magnetischen Datenaufzeichnung sind geringe Abstände zwischen dem aufzeichnenden Magnetkopf sowie dem Speichermedium Voraussetzung zum Erreichen hoher Signalpegel und hoher Speicherdichten. Insbesondere bei hohen linearen Speicherdichten führen bereits leichte Vergrößerungen des Kopf/Medium-Abstandes zu signifikaten Verschlechterungen des Signalpegels. Eine Korrosionsschutzschicht darf daher auf der dem Magnetkopf zugewandten Seite des Mediums nur eine Dicke von wenigen nm besitzen.

Im Falle von magnetooptischen und optischen Aufzeichnungsträgern muß die dem Laserstrahl zugewandte Schutzschicht eine hohe Transparenz besitzen. üblicherweise werden daher Schichten aus Metalloxid, -nitrid, oder -carbid verwendet, welche bei der Wellenlänge des aufzeichnenden Lasers einen geringen Absorptionskoeffizienten besitzen. Besagte Schutzschichten besitzen den Vorteil, daß bei der Reflexion an der Speicherschicht durch Interferenzeffekte in der transparenten Schutzschicht eine Erhöhung des magnetooptischen oder optischen Auslesesignals möglich ist. Da die Schichten in der Regel durch reaktive Kathodenzerstäubungs- oder Aufdampfprozesse hergestellt werden müssen, bedeutet eine Verwendung dieser Schichten eine wesentliche Verlängerung und damit Verteuerung des Produktionsprozesses. Außerdem ist ein effektiver Korrosionsschutz nur dann gegeben, wenn die Schutzschicht frei von Rissen oder Poren ist. Eine kostenintensive sorgfältige Qualitätskontrolle der fertiggestellten Schichten ist daher unbedingt notwendig.

Neben den transparenten Schutzschichten werden auch metallische Schichten zum Korrosionsschutz verwendet. Beispielsweise beschreibt die DE-A 3 508 476 eine Schutzschicht aus Co, Cr, Ti, Ni, Al, Au oder einer Legierung dieser Elemente mit einer Dicke im Bereich von 0,5 bis 20 nm, welche die Korrosion einer (RE-TM)-Schicht wirkungsvoll unterbindet. Es fehlen jedoch detaillierte Angaben zum Einfluß der metallischen Deckschicht auf die optischen Eigenschaften der Metallschicht, insbesondere auf das Polarisationsverhalten eines reflektierten Lichtstrahls. Kritisch auf das Reflexionsverhalten eines Lichtstrahls wirkt sich nämlich insbesondere eine Metallschicht auf der dem Laserstrahl zugewandten Seite der Speicherschicht aus. Dicken im Bereich von etwa 2 nm führen nämlich bereits zu einer starken Beeinträchtigung des Polarisationsverhaltens, wie z.B. des Kerr-Drehwinkels und damit des magnetooptischen Auslesesignals.

Aufgabe der vorliegenden Erfindung war es, eine leicht herstellbare Schutzschicht für dünne metallische Schichten zu entwickeln, welche die Korrosion dieser Schichten wirkungsvoll unterbindet, deren optisches Verhalten, insbesondere das Polarisationsverhalten eines reflektierten Lichtstrahls für beliebige Einfallwinkel jedoch unverändert läßt.

Es wurde nun gefunden, daß sich die gestellte Aufgabe lösen läßt, wenn auf der gegen Korrosion zu schützenden Oberfläche der Metalldünnschicht eine im wesentlichen aus Chrom und Chromoxid bestehende Schicht in einer Dicke von weniger als 5 nm aufgebracht wird, wobei der Gehalt an Chrom in dem der Metalldünnschicht unmittelbar benachbarten Bereich ein Maximum erreicht.

In einer besonderen Ausgestaltung der Erfindung besteht die auf der Oberfläche der Metalldünnschicht vorhandene Korrosionsschutzschicht aus mindestens einem Element der Metalldünnschicht sowie aus Chrom und einem Chromoxid. Im Rahmen der Erfindung sind auch solche transparenten Korrosionsschutzschichten geeignet, bei welchen das Chrom inselförmig vorliegt.

Gegenstand der Erfindung ist auch ein verfahren zur Herstellung dieser dünnen transparenten Korrosionsschutzschichten, wobei die gegen Korrosion zu schützende Oberfläche der Metalldünnschicht mittels eines PVD-Verfahrens mit einer zumindest inselförmigen Chromschicht in einer Dicke kleiner 3 nm belegt wird und anschließend bei Temperaturen unterhalb von 200°C, vorzugsweise bei Raumtemperatur mit einer lufthaltigen Umgebung in Kontakt gebracht wird.

Die Durchführung des erfindungsgemäßen Verfahrens geschieht beispielsweise dadurch, daß der im wesentlichen aus Trägermaterial und Metalldünnschicht bestehende Aufzeichnungsträger in eine, eine chromhaltige Materialquelle, z.B. ein Chrom-Target, aufweisende Hochvakuumanlage eingebracht wird, in welcher ein Vakuum von besser 10⁻⁶ mbar erzeugt werden kann. Damit läßt sich die vorzugsweise inselförmige Chromschicht durch Sputtern in Argon und/oder einer Reaktivgasatmosphäre, durch Aufdampfen, ggf. in einer Edelgasatmosphäre, durch Flashverdampfen oder Clusterdepostion auf die Metalldünnschicht aufbringen. Daran schließt sich dann die Oxidationsbehandlung der Chromschicht in einer lufthaltigen Atmosphäre mit ggf. variablem Sauerstoffgehalt an.

Die magnetischen Aufzeichnungsträger mit ferromagnetischer Metalldünnschicht und ihr Aufbau aus unmagnetischem Trägermaterial, gegebenenfalls unmagnetischer Zwischenschicht und ferromagnetischer Metalldünnschicht sind bekannt. Als Trägermaterial sind sowohl starre als auch flexible Materialien üblich. Vorwiegend werden Scheiben oder Folienbahnen aus Polyethylenterephthalat oder Polyimid eingesetzt. Als ferromagnetische Metalldünnschichten kommen die üblichen mit Schichtstärken von etwa 30 bis 150 nm in Frage, die in an sich bekannter Weise durch chemische Abscheidung, galvanische Abscheidung oder durch Aufdampfen bzw. Aufsputtern, d.h. Abscheidung der Metalle oder Metallegierungen im Hochvakuum auf die Träger abgeschieden werden. Als geeignete magnetische Materialien sind Eisen, Nickel, Kobalt oder deren Legierungen untereinander oder mit geringen Anteilen anderer Elemente zu nennen. Geeignete kobalthaltige ferromagnetische Metalldünnschichten sind u.a. Kobalt-, Kobalt-Bor- sowie Kobalt-Nickel-, Kobalt-Platin-, Kobalt-Nickel-Tantal-, Kobalt-Nickel-Chrom-, Kobalt-Chrom-, Kobalt-Nickel-Eisen-, Kobalt-Eisen- sowie Phosphor-, Bor- und/oder Stickstoff-enthaltende Legierungen der genannten Art, z.B. Legierungen aus 95 bis 98 % Kobalt und 2 bis 10 % Phosphor, 30 bis 20 % Nickel und 70 bis 90 % Kobalt, 90 % Kobalt, 9 % Nickel und 1 % Phosphor, 10 bis 30 % Nickel, 0 bis 10 % Tantal und 60 bis 90 % Kobalt, 10 bis 30 % Chrom und 70 bis 90 % Kobalt, 10 bis 30 % Chrom, 0 bis 10 % Tantal und 60 bis 90 % Kobalt, 88 % Kobalt, 9 % Nickel und 3 % Bor oder 40 bis 50 % Kobalt, 40 bis 50 % Nickel und 1 bis 5 % Bor. Mit diesen Legierungen lassen sich durch chemische Abscheidung auf polierten Substraten Filme von unter 60 nm Dicke herstellen mit z.B. einer Koerzitivfeldstärke von 20 bis 75 kA/m und einer Sättigungsmagnetisierung von 1 bis 1,5 Tesla. Ebenfalls geeignet sind durch einen Sputterprozeß erzeugte ferromagnetisch Schichten, welche gegebenenfalls auf eine aufgesputterte Chromzwischenschicht niedergeschlagen werden. Gleichfalls bekannt ist eine Zulegierung von Chrom zur Magnetschicht.

Die magnetooptische Aufzeichnungsträger und ihr Aufbau aus einem transparenten Trägermaterial, der ferrimagnetischen Aufzeichnungsschicht sowie gegebenenfalls zusätzlichen dielektrischen und metallischen Schichten ist bekannt.

Die optisch klaren, dimensionsstabilen Substrate bestehen im allgemeinen aus optisch transparenten keramischen Materialien oder aus Kunststoffen.

Ein Beispiel eines geeigneten optisch transparenten keramischen Materials ist Glas. Beispiele optisch klarer dimensionsstabiler Kunststoffe sind Polycarbonat, Polymethylmethacrylat oder Gemische aus Polystyrol und Polypropylenether. Diejenige Oberfläche des dimensionsstabilen Substrats, welche der magnetooptischen Aufzeichnungsschicht zugewandt ist, kann Strukturen aus erhabenen Teilen und/oder Vertiefungen zur exakten Führung des Laserstrahls oder zu sonstigen Zwecken enthalten.

Die bevorzugten amorphen ferrimagnetischen Aufzeichnungsschichten magnetooptischer Speichermedien sind an für sich bekannt und gehen beispielsweise aus der EP-A-184 034, US-A-4 693 943, DE-C-34 40 391, EP-A-302 393 oder EP-A-229 292 hervor. Beispiele geeigneter Elementkombinationen sind Sm-Co, Gd-Co, Gd-Fe, Tb-Fe, Tb-Co, Gd-Tb-Co, Nd-Fe-Co, Nd-Dy-Fe-Co, Sm-Dy-Fe-Co, Tb-Fe-Co, Gd-Tb-Fe, Gd-Fe-Co, Dy-Fe-Co, Gd-Tb-Fe-Co, von denen Gd-Tb-Co, Gd-Tb-Fe-Co und Tb-Fe-Co bevorzugt werden. Zur Verbesserung der Korrosionsstabilität können die zu verwendenden Legierungen weitere Elemente wie Chrom, Cer, Titan, Zirkonium, Niob, Tantal, Molybdän, Wolfram, Nickel, Platin, Gold, Indium, Silizium, Germanium, Antimon oder Wismut enthalten.

Das magnetoooptische Aufzeichnungsmedium kann neben dem transparenten Substrat und der ferrimagnetischen Aufzeichnungsschicht weitere dielektrische oder metallische Schichten enthalten. Weitere dielektrische Schichten, die entweder zwischen dem transparenten Substrat und der Aufzeichnungsschicht und/oder auf der dem Substrat abgewandten Seite der Aufzeichnungsschicht angeordnet sein können, bestehen in bekannter Weise aus Metallcarbiden, -oxiden, nitriden oder deren Mischungen, wobei Nitride bevorzugt und Aluminium- bzw. Siliziumnitride besonders bevorzugt werden. Des weiteren kann das magnetooptische Speichermedium auf der dem Substrat abgewandten Seite der Aufzeichnungsschicht eine oder mehrere der üblichen und bekannten Reflexionsschichten enthalten, welche zum Beispiel aus Metallen und in bevorzugter Weise aus Al-Legierungen bestehen.

Die rein optischen Aufzeichnungsmedien bestehen analog zu den magnetooptischen Aufzeichnungsmedien aus einem transparenten Trägermaterial, der Aufzeichnungsschicht sowie gegebenenfalls weiteren dielektrischen oder metallischen Schichten. Als Substrate finden die gleichen Materialien wie bei der magnetooptischen Aufzeichnung Verwendung. Die Aufzeichnungsschicht besteht üblicherweise aus Chalkogenidlegierungen, wobei Te-Legierungen besonders bevorzugt werden. Als dielektrische oder metallische Schichten finden die gleichen Materialien wie bei der magnetooptischen Aufzeichnung Verwendung.

Die erfindungsgemäßen Korrosionsschutzschichten zeichnen sich bei ihrer geringen Dicke von weniger als 5 nm durch eine unterschiedliche Konzentration an Chrom und Sauerstoff sowie gegebenenfalls einem Element der Metalldünnschicht in Abhängigkeit von der Schichtdicke aus. So erreicht der Gehalt an Chrom in dem der Metalldünnschicht unmittelbar benachbarten Bereich ein Maximum, während der Gehalt an Sauerstoff hier minimal ist. Auch das gegebenenfalls in der Korrosionsschutzschicht noch vorhandene Element der Metalldünnschicht ist vorwiegend im Grenzbereich Metalldünnschicht/Korrosionsschutzschicht vorhanden.

Eine solchermaßen gekennzeichnete Korrosionsschutzschicht weist eine hervorragende Schutzwirkung gegen Oxidation in feuchter Atmosphäre aufgrund einer starken Unterbindung der Diffusion von Sauerstoff zur Speicherschicht auf. Gleichzeitig ermöglicht der spezielle Aufbau der Schutzschicht optische Konstanten, die sich dadurch auszeichnen, daß das Polarisationsverhalten eines an der Metallschicht reflektierten Lichtstrahls bei beliebigen Einfallswinkeln durch die Korrosionsschutzschicht nicht beeinflußt wird.

Anhand der folgenden Beispiele und Vergleichsversuche sei die Erfindung näher erläutert.

Vergleichsversuch 1

Eine 100 nm dicke auf Glas aufgedampfte Co-Schicht wurde für 500 h in einer Atomosphäre mit 80° C und 80 % r.F. gelagert. Die bereits mit dem Auge wahrnehmbare deutliche Korrosion der Schichtoberfläche nach dem Test wurde mit folgenden Verfahren genauer untersucht. Es wurden von der Co-Schicht Auger-Tiefenprofile vor und nach der Klimalagerung gemessen. Vor der Lagerung betrug die Dicke der oxidierten Oberflächenzone (Abfall des O-Signals auf die Hälfte des Maximalwertes) 2 bis 3 nm. Nach der Klimalagerung wurden 17 nm gemessen.

Beispiel 1

Es wurde wie im Vergleichsversuch 1 beschrieben eine 100 nm dicke Co-Schicht auf Glas aufgedampft und mit einer gesputterten 1 nm dicken inselförmigen Cr-Schicht versehen (Ar-Druck 5 x $10^{-3}$ mbar, DC-Magnetron-Mode). Nach dem Klimatest von 500 h bei 80° C und 80 % r.F. wurde keine Änderung des Aussehens der Schichtoberfläche festgestellt. Die Auger-Tiefenprofile zeigten, daß die 1 nm dicke Cr-Schicht bei Kontakt mit der Atomosphäre nach Entnahme aus der Beschichtungsanlage sofort eine 2 nm dicke Cr-Oxid-Schicht bildet. Der Klimatest führt zu keiner weiteren Erhöhung der Oxid-Schichtdicke.

Beispiel 2

Eine 100 nm dicke $Co_{80}Ni_{20}$-Schicht wurde auf ein Glassubstrat aufgesputtert (Ar-Druck 5 x $10^{-3}$ mbar, DC-Magnetron-Mode). Diese Magnetschicht wurde mit einer 1 nm dicken Cr-Schicht besputtert. Analog wie in Beispiel 1 bildet sich eine ca. 2 nm dicke Cr-Oxidschicht, die als Korrosionsschutzschicht fungiert. Eine Lagerung bei 80°C und 80 % r.F. für 500 h ergibt sowohl optisch als auch anhand der Auger-Tiefenprofile keinen Hinweis auf eine Korrosion der (Co-Ni)-Schicht.

Vergleichsversuch 2

Wie in Beispiel 2 beschrieben, wurde eine 100 nm dicke $Co_{80}Ni_{20}$-Schicht auf Glas aufgesputtert. Zum Schutz wurde eine 10 nm dicke Cr-Schicht aufgesputtert. Nach der Klimalagerung (500 h, 80°C, 80 % r.F.) war die Oberfläche der Cr-Schutzschicht bis zu einer Tiefe von 2 nm oxidiert. Die 10 nm dicke Cr-Schicht ergab somit keine Verbesserung, jedoch war eine Reduktion des Signalpegels zu verzeichnen.

Vergleichsversuch 3

Eine 100 nm dicke (Tb-Fe-Co)-Schicht wurde auf ein Glassubstrat aufgesputtert (Ar-Druck 6 x $10^{-3}$ mbar, DC-Magnetron Mode). Die Probe wurde einem Klimatest unterworfen (80°C, 80 % r.F., 200 h). Die chemische Zusammensetzung der Probe sowie der Kerr-Drehwinkel der Probe wurden vor und nach dem Klimatest gemessen. Durch den Kontakt mit Luftsauerstoff bildete sich eine etwa 20 nm dicke Oxidschicht, die während des Klimatests auf eine Dicke > 50 nm anwuchs. Der Kerr-Drehwinkel betrug kurz nach dem Belüften der Probe 70 % des Kerr-Drehwinkels einer unoxidierten Probe. Nach dem Klimatest sank der Kerr-Drehwinkel auf unter 10 % des Ausgangswertes.

Beispiel 3

Eine 100 nm dicke (Tb-Fe-Co)-Schicht wurde auf ein Glassubstrat aufgesputtert (Ar-Druck: 6 x $10^{-3}$ mbar, DC-Magnetron Mode). Danach wurde auf die (Tb-Fe-Co)-Schicht eine inselförmige Cr-Schicht mit einer mittleren Dicke von 0,5 nm (Ar-Druck 6 x $10^{-3}$ mbar, DC-Magnetron Mode) aufgebracht. Die Cr-Schicht wurde danach durch Kontaktieren der Probe mit Luftsauerstoff oxidiert. Das Auger-Tiefenprofil der Probe zeigt eine etwa 1 nm dicke Oberflächenschicht mit einer Zusammensetzung aus O, Cr und Tb. Der O-Gehalt nimmt mit zunehmender Schichttiefe monoton ab. Der Cr-Gehalt besitzt ein inneres Maximum. Der Tb-Gehalt besitzt ein Minimum in einer Schichttiefe von etwa 0,5 nm.

Die Probe wurde einem Klimatest unterworfen (80°C, 80 % r. F., 200 h). Nach dem Klimatest zeigt sich keine Änderung der Probe, insbesondere kein Anstieg der Oxiddicke. Der Kerr-Drehwinkel der Probe vor dem Klimatest betrug mehr als 99 % des Kerr-Drehwinkels einer unoxidierten Probe. Nach dem Klimatest zeigt sich keine Änderung des Kerr-Drehwinkels.

Vergleichsversuch 4

Eine 100 nm dicke (Tb-Fe-Co)-Schicht wurde auf ein Glassubstrat aufgesputtert (Ar-Druck 6 x $10^{-3}$ mbar, DC-Magnetron Mode). Danach wurde auf die (Tb-Fe-Co)-Schicht eine 5 nm dicke Cr-Schicht aufgesputtert (Ar-Druck 6 x $10^{-3}$ mbar, DC-Magnetron Mode). Der Kerr-Drehwinkel der Probe ist gegenüber der Probe aus Beispiel 3 um mehr als 50 % reduziert. Die dickere Cr-Schicht führt also zu einer signifikaten Verschlechterung des magnetooptischen Auslegesignals.

**Patentansprüche**

1. Dünne transparente Korrosionsschutzschicht für homogene, zur Speicherung von Informationen geeignete Metalldünnschichten, dadurch gekennzeichnet, daß auf der gegen Korrosion zu schützenden Oberfläche der Metalldünnschicht eine im wesentlichen aus Chrom und Chromoxid bestehende Schicht in einer Dicke von weniger als 5 nm aufgebracht wird, wobei der Gehalt an Chrom in dem der Metalldünnschicht unmittelbar benachbarten Bereich ein Maximum erreicht.

2. Dünne transparente Korrosionsschutzschicht gemäß Anspruch 1, dadurch gekennzeichnet, daß die Schutzschicht neben Chrom und Chromoxid noch mindestens ein Element der Metalldünnschicht enthält.

3. Dünne transparente Korrosionsschutzschicht gemäß Anspruch 1, dadurch gekennzeichnet, daß das Chrom inselförmig in der Schutzschicht enthalten ist.

4. Verfahren zur Herstellung der dünnen transparenten Korrosionsschutzschicht gemäß Anspruch 1, dadurch gekennzeichnet, daß die gegen Korrosion zu schützende Oberfläche der Metalldünnschicht mittels eines PVD-Verfahrens mit einer zumindest inselförmigen Chromschicht in einer Dicke kleiner 3 nm belegt wird und anschließend bei Temperaturen unterhalb von 200°C mit einer lufthaltigen Umgebung in Kontakt gebracht wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | FR-A-2 561 023   (CANON K.K.)<br>* Seite 12, Zeile 1 - Seite 13, Zeile 14; Seite 17, Tabelle II; Ansprüche 5-7 *<br>— — — | 1,3,4 | G 11 B 5/72<br>G 11 B 11/10<br>C 23 C 14/16<br>C 23 C 14/58 |
| A | APPLIED PHYSICS LETTERS, Band 51, Nr. 7, August 1987, Seiten 542-544, New York, US; R.P. FRANKENTHAL et al.: "Duplex coatings for the protection of magneto-optic alloys against oxidation and corrosion"<br>* Insgesamt *<br>— — — | 1,3,4 | |
| A | PATENT ABSTRACTS OF JAPAN, Band 7, Nr. 101 (P-194)[1246], 28. April 1983;<br>& JP-A-58 26 323 (MATSUSHITA DENKI SANGYO K.K.) 16-02-1983<br>* Insgesamt *<br>— — — | 1,4 | |
| A | DE-A-3 534 481   (VICTOR CO. OF JAPAN)<br>* Insgesamt *<br>— — — | 1,3 | |
| A | US-A-4 554 217   (M.A. GRIMM)<br>* Spalte 3, Zeile 60 - Spalte 4, Zeile 2 *<br>— — — — — | 2 | RECHERCHIERTE SACHGEBIETE (Int. Cl.5)<br><br>C 23 C<br>G 11 B |

Der vorliegende Recherchenbericht wurde für alle Patentansprüche erstellt

| Recherchenort | Abschlußdatum der Recherche | Prüfer |
|---|---|---|
| Den Haag | 04 Juni 91 | JOFFREAU P.O. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

&  : Mitglied der gleichen Patentfamilie, übereinstimmendes Dokument